# FASCICULE DE BREVET EUROPEEN

(11) **EP 4 371 883 B1**
(45) Date de publication et mention de la délivrance du brevet: **15.01.2025**
(21) Numéro de dépôt: 23197103.7
(22) Date de dépôt: 13.09.2023
(51) Int. Cl.: B64D 27/33, B60L 58/10, G01R 31/00, G01R 31/396, H01M 10/48

(54) **PROCEDE D'AUTORISATION DE VOL D'UN AERONEF AYANT UNE INSTALLATION MOTRICE HYBRIDE MUNIE D'AU MOINS UN MOTEUR ELECTRIQUE ET D'AU MOINS UN MOTEUR THERMIQUE**
VERFAHREN ZUR FLUGAUTORISIERUNG EINES FLUGZEUGS MIT EINER HYBRID-ANTRIEBSANLAGE MIT MINDESTENS EINEM ELEKTROMOTOR UND MINDESTENS EINEM VERBRENNUNGSMOTOR
METHOD FOR AUTHORIZING THE FLIGHT OF AN AIRCRAFT HAVING A HYBRID POWER PLANT PROVIDED WITH AT LEAST ONE ELECTRIC MOTOR AND AT LEAST ONE HEAT ENGINE

(30) Priorité: 21.11.2022 FR 2212089
(43) Date de publication de la demande: 22.05.2024
(73) Titulaire: Airbus Helicopters, 13725 Marignane Cedex (FR); Airbus Defence and Space SAS, 31400 Toulouse Cedex 04 (FR)
(72) Inventeur: CAMUS, Jérémy, 13820 ENSUES LA REDONNE (FR); LAURENT, Julien, 31402 TOULOUSE Cedex 04 (FR)
(74) Mandataire: GPI Brevets

(56) Documents cités:
- WO-A1-2020/156079
- US-B1- 11 443 569

## Description

La présente invention concerne un procédé d'autorisation de vol d'un aéronef ayant une installation motrice hybride munie d'au moins un moteur électrique et d'au moins un moteur thermique, et un aéronef appliquant ce procédé.

Un aéronef peut comporter une installation motrice munie d'au moins un moteur électrique et d'au moins un moteur thermique. En particulier, un giravion peut être muni d'une telle installation motrice pour mettre en rotation au moins un rotor, éventuellement via au moins une boîte de transmission de puissance.

Un moteur électrique peut prendre la forme d'une machine électrique pouvant uniquement fonctionner en mode moteur durant lequel le moteur électrique fournit une puissance mécanique, ou d'une machine électrique apte à fonctionner dans un mode moteur électrique et dans un mode générateur électrique durant lequel le moteur électrique génère une énergie électrique. Un moteur électrique est usuellement relié électriquement à une source d'énergie électrique. La source d'énergie électrique peut comporter une pluralité d'accumulateurs électriques disposés dans une ou des batteries électriques. Un accumulateur électrique est aussi parfois dénommé cellule.

Un moteur thermique est un moteur muni d'une chambre de combustion alimentée par un carburant et un comburant, tel que par exemple un turbomoteur ou un moteur à pistons.

Par exemple, un giravion peut comporter un moteur thermique et un moteur électrique aptes chacun à mettre en mouvement un rotor principal de sustentation. Le moteur électrique peut notamment avoir pour fonction d'apporter une puissance mécanique au rotor principal en cas de panne du moteur thermique. Un tel giravion allie alors les avantages d'un giravion monomoteur, tout en présentant le niveau de sécurité d'un giravion bimoteur grâce à l'assistance apportée par le moteur électrique en cas de panne du moteur thermique. Le moteur électrique peut en effet apporter une puissance mécanique au rotor principal, suite à la panne du moteur thermique, pour une durée de quelques minutes après l'éventuelle panne du moteur thermique. Cet apport de puissance mécanique peut permettre au giravion d'atteindre une aire d'atterrissage sécurisée. Lors d'un vol au-dessus d'une ville, une telle installation motrice peut accroître la sécurité des personnes en permettant éventuellement au giravion d'atteindre une aire d'atterrissage située en dehors de la ville par exemple.

L'utilisation d'un moteur électrique au sein d'une installation motrice d'un aéronef est donc intéressante, notamment pour optimiser la sécurité de l'aéronef en cas de panne d'un moteur thermique. Toutefois, ce moteur électrique nécessite l'emploi d'un réseau électrique relié électriquement au moteur électrique. Ce réseau électrique est notamment dimensionné pour que le moteur électrique apporte la puissance mécanique souhaitée afin de réaliser la mission prévue. Le réseau électrique d'un giravion à motorisation hybride est par exemple dimensionné pour que le moteur électrique fournisse une puissance mécanique prédéterminée pendant au minimum une durée prédéterminée en cas de panne d'un moteur thermique. Un tel réseau électrique est toutefois susceptible d'être déficient et de ne pas permettre au moteur électrique de remplir la fonction souhaitée.

Le document WO2020/156079 A1 décrit un procédé et un dispositif pour surveiller une batterie électrique d'un aéronef. Ce procédé comporte l'acquisition de valeurs de paramètres de performance de la batterie électrique, ces paramètres comprenant au moins un nombre de cycles de fonctionnement, la plus petite tension électrique aux bornes d'une cellule de la batterie électrique, et une différence entre des tensions électriques aux bornes des cellules de la batterie électrique. La différence entre des tensions électriques aux bornes des cellules de la batterie électrique est mesurée entre la tension électrique de la cellule de la batterie électrique présentant la plus grande tension électrique à ses bornes et la tension électrique de la cellule de la batterie électrique présentant la plus petite tension électrique à ses bornes.

Le procédé comporte une étape de détermination d'un identifiant d'état en fonction des valeurs des paramètres de performance, l'aéronef étant contrôlé en vol pour suivre une stratégie qui est fonction de cet identifiant d'état.

Le document WO2018/171495 décrit un système de gestion d'une batterie électrique. Une puce de gestion calcule des informations de santé d'un module de cellules de la batterie électrique en fonction de données d'intensité électrique, de tension électrique et de température.

Le document US 11 443 569 B1 est aussi connu. Ce document divulgue un système de gestion d'accumulateurs électriques d'un aéronef équipé d'un propulseur électrique. On y propose de surveiller un accumulateur électrique par un capteur reflétant l'état de la batterie. Une alerte est déclenchée lorsque le signal de mesure dépasse un seuil prédéfini.

La présente invention a alors pour objet de proposer un procédé d'autorisation de vol d'un aéronef muni d'une installation motrice hybride visant à garantir avant le vol que l'aéronef peut réaliser la mission prévue.

L'invention vise un procédé d'autorisation de vol d'un aéronef muni d'une installation motrice hybride, ladite installation motrice hybride ayant au moins un moteur thermique et au moins un moteur électrique aptes chacun à mettre en mouvement un système mécanique, ledit moteur électrique étant relié électriquement à une source d'énergie électrique comprenant un nombre d'accumulateurs électriques supérieur ou égal à deux.

Ce procédé comporte les étapes suivantes :
- prélèvement au sol d'une énergie électrique ou d'une puissance électrique à prélever à partir de la source d'énergie électrique pendant une durée prédéterminée, en mettant par exemple en fonctionnement une charge électrique et/ou le moteur électrique,
- détermination pour les accumulateurs électriques de valeurs initiales d'un paramètre de fonctionnement respectivement au sein des accumulateurs électriques,
- calcul, avec un contrôleur par exemple, d'une valeur moyenne à partir des valeurs initiales,
- détermination, avec le contrôleur par exemple, d'une valeur minimale, ladite valeur minimale étant égale à la valeur initiale la plus faible parmi les valeurs initiales mesurées,
- autorisation d'un vol dudit aéronef lorsqu'une différence entre la valeur moyenne et la valeur minimale est inférieure à un seuil et interdiction du vol dudit aéronef lorsque ladite différence entre la valeur moyenne et la valeur minimale est supérieure ou égale au seuil, avec un alerteur par exemple.

Par exemple, les accumulateurs sont configurés pour présenter pour un même paramètre de fonctionnement des valeurs identiques.

Lorsqu'une énergie électrique ou une puissance électrique est prélevée sur la source d'énergie électrique, les accumulateurs électriques doivent par exemple présenter à leurs bornes des tensions électriques sensiblement identiques.

Le prélèvement au sol d'une énergie électrique ou d'une puissance électrique à prélever à partir de la source d'énergie électrique pendant une durée prédéterminée peut être réalisé à courant électrique constant ou à puissance constante, ou de manière fréquentielle.

Ce procédé permet de déterminer si la différence entre la valeur moyenne et la valeur minimale est inférieure à un seuil. Dans l'affirmative, aucun accumulateur électrique n'est défectueux. La source d'énergie électrique alimentant le moteur électrique est donc opérationnelle. Dès lors, la mission peut être effectuée et le vol peut être autorisé. Par exemple, un signal d'autorisation de vol est émis vers un alerteur et/ou aucun signal d'interdiction de vol n'est émis.

Dans la négative, le vol n'est pas autorisé. En effet, l'accumulateur électrique présentant la valeur la plus faible pour le paramètre de fonctionnement est considéré comme étant défectueux puisque la valeur minimale est éloignée de valeur moyenne. Dans ces conditions, un signal d'interdiction de vol est émis vers un alerteur et/ou aucun signal d'autorisation de vol n'est émis.

Selon un exemple, le moteur thermique peut être utilisé pour mettre en mouvement un rotor et/ou une hélice dans des conditions normales. Le moteur électrique peut être agencé notamment pour être utilisé afin de mettre en mouvement le rotor et/ou l'hélice en cas de panne du moteur thermique. Si le procédé permet de détecter avant le décollage que la source d'énergie électrique alimentant électriquement le moteur électrique est possiblement défaillant, le vol est interdit par sécurité. Le procédé permet donc de garantir qu'avant le décollage le moteur électrique est en condition d'assurer sa fonction. Le procédé permet donc de déterminer que l'aéronef sera à même de réaliser le profil de mission souhaité avant son décollage, contrairement à des systèmes faisant évoluer une stratégie en vol.

Le procédé peut comprendre une ou plusieurs des caractéristiques qui suivent, prises seules ou en combinaison.

Le prélèvement au sol d'une énergie électrique ou d'une puissance électrique à prélever à partir de la source d'énergie électrique pendant une durée prédéterminée peut selon un exemple comporter un fonctionnement en mode moteur dudit moteur électrique.

Le moteur électrique en tant que tel peut être piloté pour prélever une énergie électrique ou une puissance électrique sur la source d'énergie électrique. Le fonctionnement réel du moteur électrique est ainsi évalué. Cette caractéristique peut permettre de plus de tester le réseau électrique reliant le moteur électrique à la source d'énergie électrique, et le moteur électrique en tant que tel. Si le moteur électrique ne fonctionne pas selon un profil prédéterminé, le vol est aussi interdit.

De manière complémentaire ou alternative, ledit prélèvement au sol d'une énergie électrique ou d'une puissance électrique à prélever à partir de la source d'énergie électrique pendant une durée prédéterminée peut comporter un fonctionnement d'une charge électrique prédéterminée reliée électriquement à la source d'énergie électrique.

Eventuellement, une charge électrique, différente du moteur électrique, dédiée ou non dédiée à cette fonction est dans ces conditions alimentée électriquement par la source d'énergie électrique.

L'énergie électrique ou la puissance électrique à prélever lors de cette étape peut être égale à une unique valeur mémorisée, ou peut résulter du fonctionnement de la charge choisie. Selon une autre possibilité, l'énergie électrique ou la puissance électrique à prélever peut être réglée en pilotant au moins une charge électrique, avec le contrôleur par exemple, en fonction de la valeur d'au moins un paramètre, tel que la mission à réaliser, une température dans la source d'énergie électrique, un état de santé connu sous l'expression anglaise « State of Health », un état de charge ou un âge de la source d'énergie électrique.

Selon une possibilité compatible avec les précédentes, ladite valeur moyenne est égale à la somme des valeurs initiales divisée par ledit nombre d'accumulateurs électriques.

La valeur moyenne représente alors une moyenne arithmétique des valeurs initiales.

Selon une possibilité compatible avec les précédentes, l'autorisation d'un vol dudit aéronef peut comporter une émission d'un signal d'autorisation de vol lorsque la différence entre la valeur moyenne et la valeur minimale est inférieure au seuil.

Selon une possibilité compatible avec les précédentes, ladite interdiction du vol peut comporter une émission d'un signal d'interdiction de vol lorsque ladite différence entre la valeur moyenne et la valeur minimale est supérieure ou égale au seuil.

Selon une première variante, l'aéronef émet uniquement un signal d'autorisation de vol vers un alerteur lorsque la différence entre la valeur moyenne et la valeur minimale est inférieure au seuil. L'alerteur émet alors une alerte sonore, visuelle et/ou tactile suite à la réception du signal d'autorisation de vol. Dès lors, si aucune alerte n'est émise, le pilote en déduit que le vol est interdit et qu'une action de maintenance doit être entreprise.

Selon une deuxième variante, l'aéronef émet uniquement un signal d'interdiction de vol lorsque ladite différence entre la valeur moyenne et la valeur minimale est supérieure ou égale au seuil. L'alerteur émet alors une alerte sonore, visuelle et/ou tactile suite à la réception du signal d'interdiction de vol. Dès lors, si aucune alerte n'est émise, le pilote en déduit que le vol est autorisé.

Selon une troisième variante, l'aéronef émet un signal d'autorisation de vol vers un alerteur lorsque la différence entre la valeur moyenne et la valeur minimale est inférieure au seuil, l'alerteur générant une première alerte sonore, visuelle et/ou tactile suite à la réception du signal d'autorisation de vol. De plus, l'aéronef émet un signal d'interdiction de vol lorsque ladite différence entre la valeur moyenne et la valeur minimale est supérieure ou égale au seuil, l'alerteur générant une deuxième alerte sonore, visuelle et/ou tactile différente de la première alerte suite à la réception du signal d'interdiction de vol. En fonction de l'alerte émise, le pilote en déduit si le vol est autorisé ou interdit.

Selon une possibilité compatible avec les précédentes, le seuil peut être déterminé lors d'une phase préliminaire en réalisant successivement les étapes suivantes :
- prélèvement au sol de l'énergie électrique ou de la puissance électrique à prélever à partir de la source d'énergie électrique pendant la durée prédéterminée, et détermination pour les accumulateurs électriques de valeurs de référence respectives pour ledit paramètre de fonctionnement
- rendre inopérant un accumulateur électrique,
- prélèvement au sol de l'énergie électrique ou de la puissance électrique à prélever à partir de la source d'énergie électrique pendant la durée prédéterminée en présence d'un accumulateur électrique rendu inopérant, et détermination au moins pour le ou les accumulateurs électriques opérants de valeurs de test respectives,
- détermination, pour chaque accumulateur électrique différent dudit accumulateur électrique rendu inopérant, d'un écart entre la valeur de référence et la valeur de test correspondantes, et
- détermination dudit seuil en fonction desdits écarts.

L'expression « rendre inopérant un accumulateur électrique » signifie que l'accumulateur électrique concerné ne fournit plus un courant électrique à un moteur électrique ou une charge électrique tels que décrits précédemment.

Ce procédé permet d'établir un seuil à utiliser en simulant le dysfonctionnement d'un accumulateur, par exemple en le déconnectant électriquement des autres accumulateurs électriques.

Eventuellement le seuil peut selon un exemple être égal à la moitié du plus grand écart parmi les écarts.

L'expression « le seuil peut être égal à la moitié du plus grand écart » est à interpréter avec une marge, par exemple de 10% soit au sens « le seuil est égal à la moitié du plus grand écart plus ou moins 10 % ».

Cette caractéristique tend à éviter des effets de bords.

Selon une autre caractéristique, le seuil peut être fixe, et par exemple déterminé selon la procédure précédente.

Alternativement, le seuil peut être variable.

Par exemple, le procédé peut comporter une sélection d'une mission à effectuer parmi une liste de missions, le seuil étant variable en fonction de la mission à effectuer.

Chaque mission de la liste de missions peut être associée à un seuil respectif. La valeur du seuil pour chaque mission peut être par exemple déterminée en suivant la procédure précédente, l'énergie électrique ou de la puissance électrique à prélever variant aussi en fonction de la mission.

Eventuellement, le seuil peut être déterminé, par exemple par le contrôleur, en fonction d'au moins un paramètre, tel qu'une température dans la source d'énergie électrique, un état de santé connu sous l'expression anglaise « State of Health », un état de charge ou un âge de la source d'énergie électrique. Le contrôleur peut être configuré pour calculer le seuil en fonction de la mission à réaliser paramétrée avec une interface, une température dans la source d'énergie électrique mesurée avec un senseur de température, un état de santé de la source d'énergie électrique évalué avec un senseur de surveillance usuel, un état de charge de la source d'énergie électrique évalué avec un senseur de charge usuel, ou un âge de la source d'énergie électrique évalué avec un chronomètre usuel.

Selon une première alternative, ledit paramètre de fonctionnement peut être une tension électrique, chaque tension électrique étant mesurée à des bornes de l'accumulateur électrique associé, ladite détermination pour les accumulateurs électriques de valeurs initiales respectives d'un paramètre de fonctionnement étant réalisée durant ledit prélèvement au sol d'une énergie électrique ou d'une puissance électrique à prélever à partir de la source d'énergie électrique pendant une durée prédéterminée.

En effet, un accumulateur usagé présente une tension électrique plus faible qu'un accumulateur en bonne santé. La tension électrique peut donc représenter le paramètre de fonctionnement surveillé.

Selon une deuxième alternative, ladite détermination pour les accumulateurs électriques de valeurs initiales respectives d'un paramètre de fonctionnement comprend pour chaque accumulateur électrique : mesure d'une tension électrique primaire et d'une tension électrique secondaire à des bornes de l'accumulateur électrique associé respectivement avant et après ledit prélèvement au sol d'une énergie électrique ou d'une puissance électrique à prélever à partir de la source d'énergie électrique pendant une durée prédéterminée, ledit paramètre de fonctionnement étant une différence entre la tension électrique primaire et la tension électrique secondaire.

En effet, un accumulateur usagé présente une plus grande chute de tension électrique qu'un accumulateur en bonne santé suite à un prélèvement.

Selon une troisième alternative, la détermination pour les accumulateurs électriques de valeurs initiales respectives d'un paramètre de fonctionnement comprend pour chaque accumulateur électrique : mesure d'une tension électrique primaire et d'une tension électrique secondaire à des bornes de l'accumulateur électrique associé respectivement avant et après ledit prélèvement au sol d'une énergie électrique ou d'une puissance électrique à prélever à partir de la source d'énergie électrique pendant une durée prédéterminée, ledit paramètre de fonctionnement étant une capacité électrique fonction d'une différence entre la tension électrique primaire et la tension électrique secondaire.

La capacité électrique peut être calculée de manière usuelle en fonction de la tension électrique primaire et de la tension électrique secondaire.

Selon une quatrième alternative, ladite détermination pour les accumulateurs électriques de valeurs initiales respectives d'un paramètre de fonctionnement comprend pour chaque accumulateur électrique : mesure d'une tension électrique primaire et d'une tension électrique secondaire à des bornes de l'accumulateur électrique associé respectivement avant et après ledit prélèvement au sol d'une énergie électrique ou d'une puissance électrique à prélever à partir de la source d'énergie électrique pendant une durée prédéterminée, ledit paramètre de fonctionnement est une résistance électrique fonction d'une différence entre la tension électrique primaire et la tension électrique secondaire.

La résistance électrique peut être calculée de manière usuelle en fonction de la tension électrique primaire et de la tension électrique secondaire.

Selon une cinquième alternative, ladite détermination pour les accumulateurs électriques de valeurs initiales respectives d'un paramètre de fonctionnement comprenant pour chaque accumulateur électrique : mesure d'une évolution de température au sein de l'accumulateur électrique au moins pendant ledit prélèvement au sol d'une énergie électrique ou d'une puissance électrique à prélever à partir de la source d'énergie électrique pendant une durée prédéterminée, ledit paramètre de fonctionnement étant fonction de ladite évolution de température.

Par exemple, le paramètre de fonctionnement est le coefficient directeur d'une pente d'une courbe décrite par la température mesurée. Un accumulateur usagé présente une pente plus importante qu'un accumulateur en bonne santé.

Outre un procédé, l'invention vise un programme d'ordinateur comprenant des instructions qui, lorsque ledit programme est exécuté par un système, conduisent ledit système à mettre en oeuvre ce procédé.

Outre un procédé, l'invention vise également un aéronef configuré pour mettre en oeuvre ce procédé. L'aéronef est muni d'une installation motrice hybride, ladite installation motrice hybride ayant au moins un moteur thermique et au moins un moteur électrique aptes chacun à mettre en mouvement un système mécanique, ledit moteur électrique étant relié électriquement à une source d'énergie électrique comprenant un nombre d'accumulateurs électriques supérieur ou égal à deux. L'aéronef comporte de plus un système d'autorisation de vol configuré pour mettre en oeuvre le procédé de l'invention.

Eventuellement, le système d'autorisation de vol peut comporter un senseur configuré pour au moins participer à une mesure des valeurs initiales d'un paramètre de fonctionnement respectivement au sein des accumulateurs électriques, par exemple en mesurant des tensions électriques respectivement à des bornes des accumulateurs électriques ou des températures au sein de chaque accumulateur électrique, un contrôleur configuré pour requérir le prélèvement au sol d'une énergie électrique ou d'une puissance électrique à prélever à partir de la source d'énergie électrique pendant une durée prédéterminée ainsi que pour calculer la valeur moyenne et la valeur minimale et pour déterminer si une différence entre la valeur moyenne et la valeur minimale est inférieure à un seuil ou est supérieure ou égale au seuil, et un alerteur configuré pour générer au moins une autorisation de vol ou une interdiction de vol.

Le contrôleur et/ou le senseur peuvent être des parties de la source d'énergie électrique.

Dès lors, le contrôleur est en communication avec le senseur. Le senseur émet un ou des signaux de mesure porteurs des valeurs initiales, voire des valeurs de test et/ou des valeurs de référence. Le contrôleur reçoit le ou les signaux de mesure pour déterminer la valeur minimale et la valeur moyenne, voire les écarts précités. Le contrôleur compare alors la différence entre la valeur moyenne et la valeur minimale à un seuil. En conséquence, le contrôleur transmet un signal d'autorisation de vol ou d'interdiction de vol à l'alerteur.

Le contrôleur ou un autre calculateur peut recevoir le ou les signaux de mesure pour déterminer les écarts de tension lors d'une phase préliminaire.

L'invention et ses avantages apparaîtront avec plus de détails dans le cadre de la description qui suit avec des exemples donnés à titre illustratif en référence aux figures annexées qui représentent :
la figure 1, un schéma illustrant une mission d'un aéronef selon l'invention,
la figure 2, un schéma illustrant un aéronef selon l'invention,
la figure 3, un schéma illustrant le procédé selon l'invention, et
la figure 4, un diagramme illustrant la détermination de la valeur du seuil.

Les éléments présents dans plusieurs figures distinctes sont affectés d'une seule et même référence.

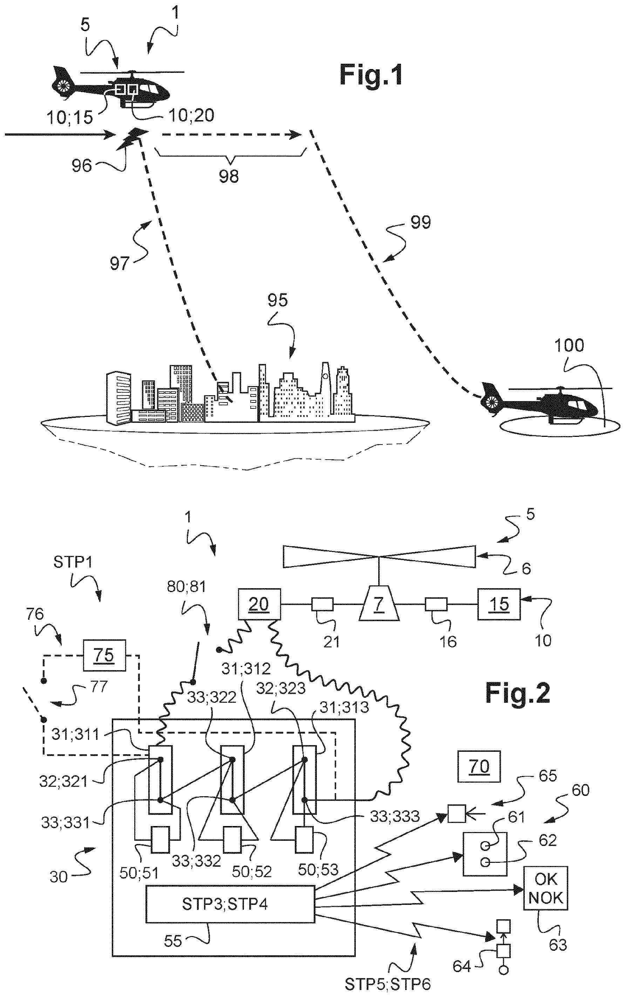

La figure 1 présente un aéronef 1 selon l'invention. Cet aéronef 1 est muni d'une installation motrice hybride 10. L'installation motrice hybride 10 comporte au moins un moteur thermique 15 et au moins un moteur électrique 20 qui sont tous les deux aptes à mettre en mouvement un système mécanique 5, voire uniquement un moteur thermique 15 et un moteur électrique 20. Le système mécanique 5 peut avoir pour fonction de participer à l'avancement et/ou à la propulsion de l'aéronef 1.

Par exemple, le moteur thermique 15 est par défaut en fonctionnement, le moteur électrique 20 ayant pour fonction de pallier une panne du moteur thermique 15.

Sur un aéronef classique, suite à une panne 96 du moteur thermique, l'aéronef effectue une descente 97. Par exemple, un hélicoptère effectue un vol dit en « autorotation ». Lors d'un survol d'une zone urbaine 95, l'aéronef est susceptible de se diriger vers cette zone.

Avec un aéronef 1 selon l'invention muni d'une installation motrice hybride 10, suite à la panne 96 le moteur électrique 20 prend le relais du moteur thermique 15 et met en mouvement le système mécanique 5. Pendant une certaine durée, l'aéronef 1 peut poursuivre son vol durant une phase de vol 98 motorisée électriquement, puis effectue une descente 99. Par exemple, un hélicoptère effectue un vol dit en « autorotation ». Lors d'un survol d'une zone urbaine 95, l'aéronef 1 est susceptible de s'éloigner de cette zone urbaine pour atteindre une zone sécurisée 100.

Un aéronef 1 selon l'invention permet à un pilote de s'assurer que le système de motorisation électrique est fonctionnel avant le décollage.

La figure 2 présente schématiquement un tel aéronef 1.

Ainsi, l'aéronef 1 est muni d'une installation motrice hybride 10. Cette installation motrice hybride 10 comporte au moins un moteur thermique 15 configuré pour mettre en mouvement un système mécanique 5. Le moteur thermique 15 est en outre alimenté en carburant par au moins un réservoir non représenté pour ne pas alourdir la figure 2.

De plus, cette installation motrice hybride 10 comporte au moins un moteur électrique 20 configuré pour mettre en mouvement le système mécanique 5. Le moteur électrique 20 peut être un organe moteur fonctionnant uniquement en mode moteur durant lequel le moteur électrique fournit une puissance mécanique au système mécanique 5, ou peut être une machine électrique apte à fonctionner en fonction du besoin selon un mode moteur et un mode générateur électrique durant lequel le moteur électrique génère une énergie électrique en étant mis en mouvement par le système mécanique 5.

Par exemple, le système mécanique 5 comporte au moins un rotor 6, au moins une boîte de transmission de puissance 7, au moins une roue libre 16, 21 et/ou au moins un connecteur mécanique. Un moteur thermique 15 peut être relié par une roue libre 16 à une boîte de transmission de puissance 7 mettant en mouvement au moins un rotor 6. De plus, un moteur électrique 20 peut être relié par une roue libre 21 à la boîte de transmission de puissance 7.

Par ailleurs, le moteur électrique 20 est relié électriquement par un réseau électrique moteur 80 à une source d'énergie électrique 30. Le réseau électrique moteur 80 peut comprendre un organe de connexion/déconnexion 81 permettant de relier électriquement sur commande le moteur électrique 20 à la source d'énergie électrique 30. L'organe de connexion/déconnexion 81 peut prendre la forme d'un interrupteur, d'un relais ou autres.

La source d'énergie électrique 30 comprend plusieurs accumulateurs électriques 31. Les accumulateurs électriques 31 peuvent être rechargeables. En particulier, la source d'énergie électrique 30 est munie d'un nombre d'accumulateurs électriques 31 supérieur ou égale à deux. Selon l'exemple illustré, la source d'énergie électrique 30 est munie de trois accumulateurs électriques 311, 312, 313.

La référence « 31 » est utilisée pour désigner n'importe quel accumulateur électrique, les références 311, 312 et 313 étant utilisées pour désigner si besoin un accumulateur électrique spécifique afin d'expliciter l'invention.

Les accumulateurs électriques 31 peuvent être reliés électriquement en série et/ou en parallèle par des liaisons filaires, des liaisons de type PCB (printed circuit board en langue anglaise), des soudures, des feuillards de cuivre, etc.

Les accumulateurs électriques 31 peuvent être regroupés au sein d'une ou de plusieurs batteries.

Par ailleurs, l'aéronef 1 comporte un système 40 d'autorisation de vol configuré pour déterminer a minima si la source d'énergie électrique 30 est apte à délivrer un courant électrique et/ou une puissance électrique prédéterminé au moteur électrique 20, afin que le moteur électrique 20 puisse réaliser sa ou ses fonctions.

Le système 40 d'autorisation de vol peut comporter un senseur 50 configuré pour participer à la détermination des valeurs initiales d'un paramètre de fonctionnement respectivement des accumulateurs électriques 31. Ainsi, pour chaque accumulateur électrique 31, le senseur 50 est configuré pour émettre un ou des signaux analogiques ou numériques porteurs d'une information relative à la valeur initiale d'un paramètre de fonctionnement au sein de cet accumulateur électrique 31.

Eventuellement, le senseur 50 peut être une partie d'une batterie électrique.

Par senseur 50, on entend ici un système de mesure capable de mesurer les valeurs requises. De manière similaire, le terme « mesure » désigne aussi bien une mesure brute issue d'un signal émis par un capteur qu'une mesure obtenue par un traitement de signal plus ou moins complexe à partir de mesures brutes.

Selon une possibilité, le paramètre de fonctionnement peut être fonction d'une tension électrique, chaque tension électrique étant mesurée à des bornes 32, 33 de l'accumulateur électrique 31 associé.

Les références « 32 » et « 33 » sont utilisées pour désigner les deux bornes de n'importe quel accumulateur électrique 31, les références 321-331, 322-332, 323-333 étant utilisées pour désigner les bornes d'accumulateurs électriques 311, 312 et 313 spécifiques.

Ainsi, selon l'exemple illustré le premier accumulateur électrique 311 comporte une première borne 321 et une deuxième borne 331, le deuxième accumulateur électrique 312 comporte une première borne 322 et une deuxième borne 332 et le troisième accumulateur électrique 313 comporte une première borne 323 et une deuxième borne 333. Dès lors, le senseur 50 mesure une tension électrique aux bornes 321 et 331 du premier accumulateur électrique 311, une autre tension électrique aux bornes 322 et 332 du deuxième accumulateur électrique 312 et une autre tension électrique aux bornes 323 et 333 du troisième accumulateur électrique 313.

Ainsi, le senseur 50 peut comporter par exemple un capteur 51, 52, 53 par accumulateur électrique 311, 312, 313 pour mesurer des tensions électriques au bornes 321 et 331, 322 et 332, 323 et 333 de ces accumulateurs électriques 311, 312, 313. Par exemple, chaque capteur 51, 52, 53 peut prendre la forme d'un Voltmètre.

Selon une autre possibilité, ledit paramètre de fonctionnement est fonction d'une évolution de température au sein de l'accumulateur électrique 31. Le senseur 50 peut alors comprendre un senseur de température par accumulateur électrique.

Par ailleurs, le système 40 d'autorisation de vol peut comporter un contrôleur 55 relié au senseur 50 par une communication filaire ou non filaire, et le cas échéant à chaque capteur 51, 52, 53.

Le contrôleur 55 peut être muni d'une ou de plusieurs unités de traitement comprenant par exemple au moins un processeur et au moins une mémoire, au moins un circuit intégré, au moins un système programmable, au moins un circuit logique, ces exemples ne limitant pas la portée donnée à l'expression « unité de traitement ». Le terme processeur peut désigner aussi bien une unité centrale de traitement connue sous l'acronyme CPU, une unité graphique de traitement GPU, une unité digitale connue sous l'acronyme DSP, un microcontrôleur... Eventuellement, une ou des unités de traitement du contrôleur 55 peuvent être des parties d'une batterie électrique ou peuvent être déportées voire peuvent aussi exercer d'autres fonctions. Une ou des unités de traitement du contrôleur 55 peuvent être dédiées ou non dédiées à l'invention.

Le contrôleur 55 peut en outre être relié à une interface homme-machine de commande 70 par une liaison filaire et/ou non filaire, directement ou indirectement via d'autres organes et par exemple un calculateur avionique. Cette interface homme-machine de commande 70 peut transmettre un signal analogique ou numérique au contrôleur 55 pour mettre en oeuvre le procédé de l'invention.

Par ailleurs, le système 40 d'autorisation de vol peut comprendre un alerteur 60. L'alerteur 60 peut être relié au contrôleur 55 par une communication filaire ou non filaire. Le contrôleur 55 est configuré pour transmette un ou des signaux d'alerte analogiques ou numériques à l'alerteur 60. L'alerteur 60 est configuré pour générer au moins une autorisation de vol ou une interdiction de vol visuelle, sonore et/ou tactile.

Par exemple, l'alerteur 60 peut comprendre une diode électroluminescente 61 allumée lorsqu'une autorisation de vol est accordée par le contrôleur 55, et/ou une autre diode électroluminescente 62 allumée lorsqu'une interdiction de vol est émise par le contrôleur 55.

Par exemple, l'alerteur 60 peut comprendre une unité vibrante 64 faisant vibrer un organe tenu ou porté par un individu, l'unité vibrante 64 pouvant générer dans ledit organe une première vibration lorsqu'une autorisation de vol est accordée par le contrôleur 55, et/ou une deuxième vibration lorsqu'une interdiction de vol est émise par le contrôleur 55. Le cas échéant, la première vibration et la deuxième vibration peuvent être différentes.

Par exemple, l'alerteur 60 peut comprendre un haut parleur 65 pouvant émettre un premier son lorsqu'une autorisation de vol est accordée par le contrôleur 55, et/ou un deuxième son lorsqu'une interdiction de vol est émise par le contrôleur 55. Le cas échéant, le premier son et le deuxième son peuvent être différents.

Selon un autre aspect, le système 40 d'autorisation de vol peut comporter une charge électrique 75 reliée électriquement par un réseau électrique de prélèvement 76 à la source d'énergie électrique 30. Le réseau électrique de prélèvement 76 peut comprendre un moyen de connexion/déconnexion 77 permettant de relier électriquement sur commande la charge électrique 75 à la source d'énergie électrique 30. Le moyen de connexion/déconnexion 77 peut prendre la forme d'un interrupteur, d'un relais ou autres.

Le cas échéant, le contrôleur 55 peut être relié par une liaison filaire ou non filaire à l'organe de connexion/déconnexion 81 et/ou au moyen de connexion/déconnexion 77 précédemment décrits.

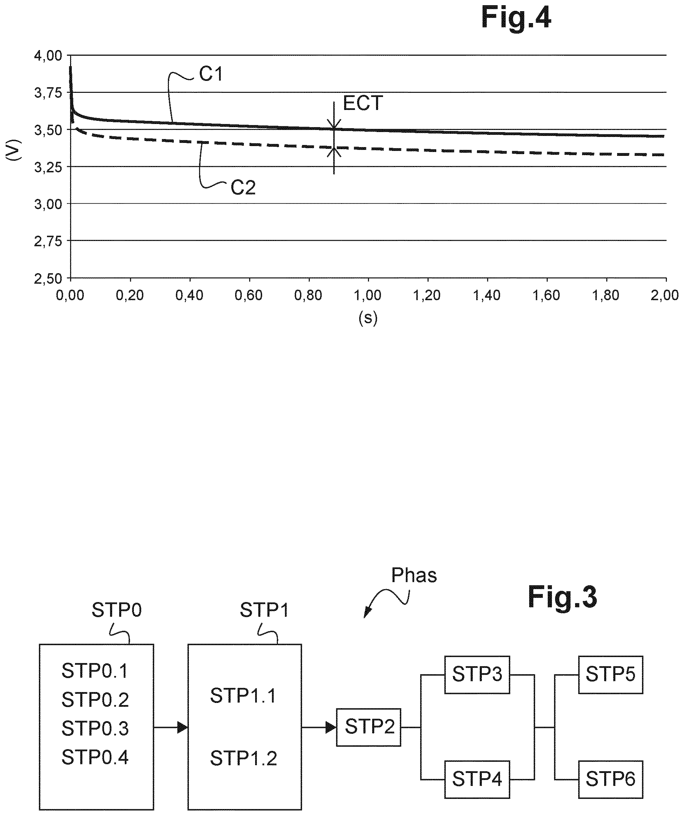

La figure 3 illustre le procédé de l'invention. Ce procédé peut être mise en oeuvre par un programme d'ordinateur comprenant des instructions. Lorsque ledit programme est exécuté par le système 40, les instructions exécutées conduisent le système 40 à mettre en oeuvre ce procédé.

Le procédé comporte une phase de surveillance Phas, réalisée préalablement au décollage, par exemple au démarrage de l'aéronef 1. Eventuellement, la phase de surveillance peut être initiée lorsque l'interface homme-machine de commande 70 est manoeuvrée. Par exemple, l'interface homme-machine de commande 70 transmet directement un signal de commande au contrôleur 55, ou transmet un signal à un organe tiers qui transmet à son tour directement ou indirectement un signal de commande au contrôleur 55.

Durant la phase de surveillance Phas, le procédé comporte un prélèvement STP1 au sol d'une énergie électrique ou d'une puissance électrique à prélever à partir de la source d'énergie électrique 30 pendant une durée prédéterminée.

Par exemple, cette étape comporte le fonctionnement STP1.1 en mode moteur du moteur électrique 20.

Eventuellement, le contrôleur 55 peut piloter le réseau électrique moteur 80 pour qu'un courant électrique circule entre le moteur électrique 20 et la source d'énergie électrique 30. Par exemple, le contrôleur 55 pilote l'organe de connexion/déconnexion 81.

De manière complémentaire ou alternative, le contrôleur 55 peut piloter le réseau électrique de prélèvement 76 pour qu'un courant électrique circule entre la charge électrique 75 et la source d'énergie électrique 30. Par exemple, le contrôleur 55 pilote le moyen de connexion/déconnexion 76.

Eventuellement, la durée prédéterminée peut être fixe ou calculée, par exemple par le contrôleur 55. Selon une illustration, le contrôleur 55 est configuré pour calculer la durée prédéterminée en fonction d'une température extérieure mesurée avec un capteur de température.

Dès lors, avant et/ou pendant et/ou après ce prélèvement d'une énergie électrique ou d'une puissance électrique, la phase de surveillance Phas comporte la détermination STP2 pour les accumulateurs électriques 31 de valeurs initiales Vmes respectives pour un paramètre de fonctionnement.

Dès lors, la phase de surveillance Phas comporte un calcul STP3 avec le contrôleur 55 d'une valeur moyenne Vmoy à partir des valeurs initiales Vmes.

Selon une première alternative réalisable avec le système de la figure 2, le senseur 55 mesure une tension électrique initiale Vmes1 aux bornes 321 et 331 du premier accumulateur 311, une deuxième tension électrique initiale Vmes2 aux bornes 322 et 332 du deuxième accumulateur 312 et une troisième tension électrique initiale Vmes3 aux bornes 323 et 333 du troisième accumulateur 313.

Pour chaque accumulateur électrique 30, la valeur initiale Vmes peut être la tension électrique mesurée en temps réel et à un instant prédéterminé, ou peut être égale à une moyenne des tensions électriques mesurées pendant ladite durée prédéterminée.

Les tensions électriques initiales Vmes peuvent être mémorisées dans une mémoire du contrôleur 55 ou d'une dans une autre mémoire.

Dès lors, la phase de surveillance Phas comporte un calcul STP3 avec le contrôleur 55 d'une valeur moyenne Vmoy à partir des tensions électriques initiales Vmes.

La valeur moyenne Vmoy est par exemple égale à la somme des tensions électriques initiales Vmes divisée par ledit nombre Nbr. Selon l'exemple de la figure 2, la valeur moyenne Vmoy est par exemple égale à la somme de la première tension électrique Vmes1 et de la deuxième tension électrique Vmes2 et de la troisième tension électrique Vmes3 divisée par 3 soit Vmoy = (Vmes1+Vmes2+Vmes3)/3.

Selon une deuxième alternative réalisable avec le système de la figure 2, le senseur 50 mesure pour chaque accumulateur électrique 31 une tension électrique primaire et une tension électrique secondaire respectivement avant et après ledit prélèvement au sol d'une énergie électrique ou d'une puissance électrique à prélever à partir de la source d'énergie électrique 30 pendant une durée prédéterminée. Pour chaque accumulateur électrique 31, le contrôleur 55 calcule la valeur initiale Vmes associée, cette valeur initiale Vmes étant égale à une différence entre la tension électrique primaire et la tension électrique secondaire.

La valeur moyenne Vmoy est par exemple égale à la somme des valeurs initiales Vmes divisée par ledit nombre Nbr.

Selon une troisième alternative réalisable avec le système de la figure 2, le senseur 50 mesure pour chaque accumulateur électrique 31 une tension électrique primaire et une tension électrique secondaire respectivement avant et après ledit prélèvement au sol d'une énergie électrique ou d'une puissance électrique à prélever à partir de la source d'énergie électrique 30 pendant une durée prédéterminée. Pour chaque accumulateur électrique 31, le contrôleur 55 calcule la valeur initiale Vmes associée, cette valeur initiale Vmes étant une capacité électrique fonction d'une différence entre la tension électrique primaire et la tension électrique secondaire.

La valeur moyenne Vmoy est par exemple égale à la somme des valeurs initiales Vmes divisée par ledit nombre Nbr.

Selon une quatrième alternative réalisable avec le système de la figure 2, le senseur 50 mesure pour chaque accumulateur électrique 31 une tension électrique primaire et une tension électrique secondaire respectivement avant et après ledit prélèvement au sol d'une énergie électrique ou d'une puissance électrique à prélever à partir de la source d'énergie électrique 30 pendant une durée prédéterminée. Pour chaque accumulateur électrique 31, le contrôleur 55 calcule la valeur initiale Vmes associée, cette valeur initiale Vmes étant une résistance électrique fonction d'une différence entre la tension électrique primaire et la tension électrique secondaire.

La valeur moyenne Vmoy est par exemple égale à la somme des valeurs initiales Vmes divisée par ledit nombre Nbr.

Selon une cinquième alternative, le senseur 50 mesure pour chaque accumulateur électrique 31 une température au sein de cet accumulateur électrique 31 au moins pendant, voire aussi avant et/ou après ledit prélèvement au sol d'une énergie électrique ou d'une puissance électrique à prélever à partir de la source d'énergie électrique 30 pendant une durée prédéterminée. Pour chaque accumulateur électrique 31, le contrôleur 55 calcule la valeur initiale Vmes associée, cette valeur initiale Vmes étant fonction de ladite évolution de température. Par exemple, le paramètre de fonctionnement est le coefficient directeur d'une pente d'une courbe décrite par la température mesurée.

La valeur moyenne Vmoy est par exemple égale à la somme des valeurs initiales Vmes divisée par ledit nombre Nbr.

Indépendamment de la manière d'évaluer les valeurs initiales Vmes ainsi que la valeur moyenne Vmoy et en référence à la figure 3, la phase de surveillance Phas comporte aussi la détermination STP4 d'une valeur minimale Vmin. Le contrôleur 55 peut déterminer la valeur minimale Vmin, cette valeur minimale Vmin étant égale à la valeur initiale Vmes la plus faible parmi les valeurs initiales Vmes mesurées.

Dès lors, le contrôleur 55 transmet un signal à l'alerteur 60 afin de générer une autorisation de vol de l'aéronef 1 lorsqu'une différence Diff entre la valeur moyenne Vmoy et la valeur minimale Vmin est inférieure à un seuil S prédéterminé, et une interdiction du vol de l'aéronef 1 lorsque ladite différence Diff est supérieure ou égale au seuil S.

A titre illustratif, selon l'exemple de la première alternative et l'exemple de la figure 2 la première tension électrique est égale à 2.7 Volts, la deuxième tension électrique est égale à 3.5 Volts et la troisième tension électrique est égale à 3.4 Volts. La tension électrique moyenne Vmoy est alors égale à 3.2 Volts et la tension électrique minimale Vmin est égale à la première tension électrique soit 2.7 Volts.

Si le seuil est fixé à 0.3 Volt, alors la différence entre la tension électrique moyenne Vmoy et la tension électrique minimale Vmin vaut 0.5 Volts et est supérieure au seuil S. Le vol est alors interdit. Une action de maintenance peut alors être déclenchée.

Si le seuil est fixé à 0.6 Volt, alors la différence entre la tension électrique moyenne Vmoy et la tension électrique minimale Vmin est inférieure au seuil. Le vol est alors autorisé.

Pour autoriser le vol, le contrôleur 55 peut émettre un signal d'autorisation de vol lorsque la différence entre la valeur Vmoy et la valeur minimale Vmin est inférieure au seuil S. A réception du signal d'autorisation de vol, l'alerteur 60 peut alors soit ne générer aucune alerte dans le cas où l'alerteur 60 émet seulement une alerte en cas d'interdiction, soit générer une alerte porteuse de l'autorisation de vol.

Pour interdire le vol, le contrôleur 55 peut émettre un signal d'interdiction de vol lorsque la différence entre la valeur moyenne Vmoy et la valeur minimale Vmin est supérieure ou égale au seuil S. A réception du signal d'interdiction de vol, l'alerteur 60 peut alors soit ne générer aucune alerte dans le cas où l'alerteur 60 émet seulement une alerte en cas d'autorisation de vol, soit générer une alerte porteuse de l'interdiction de vol.

Selon un autre aspect, le seuil peut être fixe ou peut varier en fonction de la situation rencontrée. Par exemple, un pilote peut solliciter une interface homme-machine de mission pour sélectionner une mission à effectuer dans une liste de missions prédéterminée, le contrôleur 55 pouvant déterminer la valeur du seuil S à l'aide d'une liste mémorisant pour chaque mission une dite valeur du seuil S.

Selon une éventualité, le contrôleur 55 peut calculer le seuil en fonction d'une température dans la source d'énergie électrique mesurée avec un senseur de température, d'un état de santé de la source d'énergie électrique évalué avec un senseur de surveillance usuel, d'un état de charge de la source d'énergie électrique évalué avec un senseur de charge usuel, et/ou d'un âge de la source d'énergie électrique évalué avec un chronomètre usuel.

La valeur du seuil S ou une loi permettant de calculer cette valeur en fonction d'un ou de plusieurs paramètres peut être établie par essais ou simulations par exemple.

Pour évaluer la valeur du seuil S, par exemple pour une mission particulière ou pour certaines valeurs de certains paramètres, le procédé peut éventuellement comprendre une phase préliminaire STP0. Cette phase préliminaire STP0 peut comporter un prélèvement STP0.1 au sol de l'énergie électrique ou de la puissance électrique à prélever évoquée précédemment à partir de la source d'énergie électrique 30 pendant la durée prédéterminée évoquée précédemment. Par exemple, cette étape STP0.1 comporte le fonctionnement en mode moteur du moteur électrique 20 ou l'alimentation électrique d'une charge électrique 75 à l'instar de l'étape STP1 précédemment décrite.

La phase préliminaire STP0 comporte la mesure STP0.2, avec le senseur 50 pour les accumulateurs électriques 31 de valeurs de référence Vref respectives, chaque tension électrique de référence Vref selon la première alternative étant mesurée aux bornes 32,33 de l'accumulateur électrique 31 associé.

Les valeurs de référence Vref sont mémorisées pour un traitement ultérieur, par exemple dans une mémoire du contrôleur 55 ou d'une autre unité de traitement.

La phase préliminaire STP0 comporte une étape STPO.3 consistant à rendre inopérant un accumulateur électrique 31, par exemple l'accumulateur électrique 311 de la figure 2, pour évaluer la valeur du seuil. Par exemple, un opérateur modifie le câblage de la source d'énergie électrique 30 pour déconnecter l'accumulateur électrique 311 concerné, ou le contrôleur 55 agit sur un ou des interrupteurs ou un équivalent pour atteindre le même effet.

Dès lors, la phase préliminaire STP0 comporte un prélèvement STPO.4 au sol de l'énergie électrique ou de la puissance électrique à prélever à partir de la source d'énergie électrique 30 pendant la durée prédéterminée en présence d'un accumulateur électrique 31 rendu inopérant, à savoir le premier accumulateur électrique 311 selon l'exemple donné, et une mesure STP0.5 pour les accumulateurs électriques 31 de valeurs de test Vtest respectives.

Les étapes de références STP0.1 et STP0.2 sont en effet reproduites avec un accumulateur électrique 31 inopérant pour simuler un dysfonctionnement de la source d'énergie électrique 30.

Dés lors, une unité de traitement et par exemple le contrôleur 55 détermine, pour chaque accumulateur électrique 31 différent de l'accumulateur électrique rendu inopérant, un écart entre la valeur de référence Vref et la valeur de test Vtest correspondantes.

La figure 4 illustre la variation de la tension électrique de référence Vref et de la tension électrique de test Vtest au fil du temps dans le cadre de la première alternative. Cette figure 4 présente en abscisse le temps, et en ordonnée une tension électrique. La courbe C1 représente la tension électrique de référence Vref et la courbe C2 représente la tension électrique de test Vtest.

On constate qu'à chaque instant un écart ECT sépare la courbe C1 et la courbe C2. En effet, en cas de défaillance d'un accumulateur électrique 31, l'énergie électrique ou la puissance électrique prélevée au niveau des autres accumulateurs électriques 31 est plus importante qu'en l'absence d'accumulateurs électriques 31 en panne.

Dès lors, le procédé comporte la détermination dudit seuil S en fonction desdits écarts de tension, par exemple à l'aide d'une unité de traitement voire du contrôleur 55.

Eventuellement, le seuil S peut être égal à la moitié du plus grand écart de tension parmi les écarts de tension relevés.

Naturellement, la présente invention est sujette à de nombreuses variations quant à sa mise en oeuvre, tout en restant dans le cadre des revendications. Bien que plusieurs modes de réalisation aient été décrits, on comprend bien qu'il n'est pas concevable d'identifier de manière exhaustive tous les modes possibles.

## Revendications

1. Procédé d'autorisation de vol d'un aéronef (1) muni d'une installation motrice hybride (10), ladite installation motrice hybride (10) ayant au moins un moteur thermique (15) et au moins un moteur électrique (20) aptes chacun à mettre en mouvement un système mécanique (5), ledit moteur électrique (20) étant relié électriquement à une source d'énergie électrique (30) comprenant un nombre (Nbr) d'accumulateurs électriques (31) supérieur ou égal à deux, le procédé comportant les étapes suivantes :
- prélèvement (STP1) au sol d'une énergie électrique ou d'une puissance électrique à prélever à partir de la source d'énergie électrique (30) pendant une durée prédéterminée,
- détermination (STP2) pour les accumulateurs électriques (31) de valeurs initiales (Vmes) d'un paramètre de fonctionnement respectivement au sein des accumulateurs électriques(31),
- calcul (STP3) d'une valeur moyenne (Vmoy) à partir des valeurs initiales (Vmes),
- détermination (STP4) d'une valeur minimale (Vmin), ladite valeur minimale (Vmin) étant égale à la valeur initiale (Vmes) la plus faible parmi les valeurs initiales (Vmes) mesurées,
- autorisation d'un vol dudit aéronef (1) lorsqu'une différence entre la valeur moyenne (Vmoy) et la valeur minimale (Vmin) est inférieure à un seuil (S) et interdiction du vol dudit aéronef (1) lorsque ladite différence entre la valeur moyenne (Vmoy) et la valeur minimale (Vmin) est supérieure ou égale au seuil (S).

2. Procédé selon la revendication 1, dans lequel ledit prélèvement (STP1) au sol d'une énergie électrique ou d'une puissance électrique à prélever à partir de la source d'énergie électrique (30) pendant une durée prédéterminée comporte un fonctionnement (STP1.1) en mode moteur dudit moteur électrique (20).

3. Procédé selon l'une quelconque des revendications 1 à 2, dans lequel ledit prélèvement (STP1) au sol d'une énergie électrique ou d'une puissance électrique à prélever à partir de la source d'énergie électrique pendant une durée prédéterminée comporte un fonctionnement (STP1.2) d'une charge électrique (75) prédéterminée reliée électriquement à la source d'énergie électrique (30).

4. Procédé selon l'une quelconque des revendications 1 à 3, dans lequel ladite valeur moyenne (Vmoy) est égale à la somme des valeurs initiales (Vmes) divisée par ledit nombre (Nbr).

5. Procédé selon l'une quelconque des revendications 1 à 4, dans lequel ladite autorisation d'un vol dudit aéronef (1) comporte une émission d'un signal d'autorisation de vol lorsque la différence entre la valeur moyenne (Vmoy) et la valeur minimale (Vmin) est inférieure au seuil (S).

6. Procédé selon l'une quelconque des revendications 1 à 5, dans lequel ladite interdiction du vol comporte une émission d'un signal d'interdiction de vol lorsque ladite différence entre la valeur moyenne (Vmoy) et la valeur minimale (Vmin) est supérieure ou égale au seuil (S).

7. Procédé selon l'une quelconque des revendications 1 à 6, dans lequel ledit seuil (S) est déterminé lors d'une phase préliminaire (STP0) en réalisant successivement les étapes suivantes :
- prélèvement (STP0.1) au sol de l'énergie électrique ou de la puissance électrique à prélever à partir de la source d'énergie électrique (30) pendant la durée prédéterminée, et détermination pour les accumulateurs électriques (31) de valeurs de référence (Vref) respectives pour ledit paramètre de fonctionnement, ,
- rendre inopérant un accumulateur électrique (311),
- prélèvement au sol de l'énergie électrique ou de la puissance électrique à prélever à partir de la source d'énergie électrique (30) pendant la durée prédéterminée en présence d'un accumulateur électrique (311) rendu inopérant, et détermination au moins pour le ou les accumulateurs électriques opérants de valeurs de test (Vtest) respectives pour ledit paramètre de fonctionnement,
- détermination, pour chaque accumulateur électrique (31) différent dudit accumulateur électrique rendu inopérant, d'un écart entre la valeur de référence (Vref) et la valeur de test (Vtest) correspondantes,
- détermination dudit seuil (S) en fonction desdits écarts.

8. Procédé selon la revendication 7, dans lequel ledit seuil (S) est égal à la moitié du plus grand écart parmi les écarts.

9. Procédé selon l'une quelconque des revendications 1 à 8, dans lequel ledit seuil (S) est fixe ou variable.

10. Procédé selon l'une quelconque des revendications 1 à 9, dans lequel ledit paramètre de fonctionnement est une tension électrique, chaque tension électrique étant mesurée à des bornes de l'accumulateur électrique (31) associé, ladite détermination (STP2) pour les accumulateurs électriques (31) de valeurs initiales (Vmes) respectives d'un paramètre de fonctionnement étant réalisée durant ledit prélèvement (STP1) au sol d'une énergie électrique ou d'une puissance électrique à prélever à partir de la source d'énergie électrique (30) pendant une durée prédéterminée.

11. Procédé selon l'une quelconque des revendications 1 à 9, dans lequel ladite détermination (STP2) pour les accumulateurs électriques (31) de valeurs initiales (Vmes) respectives d'un paramètre de fonctionnement comprend pour chaque accumulateur électrique : mesure d'une tension électrique primaire et d'une tension électrique secondaire à des bornes de l'accumulateur électrique (31) associé respectivement avant et après ledit prélèvement (STP1) au sol d'une énergie électrique ou d'une puissance électrique à prélever à partir de la source d'énergie électrique (30) pendant une durée prédéterminée, ledit paramètre de fonctionnement étant une différence entre la tension électrique primaire et la tension électrique secondaire.

12. Procédé selon l'une quelconque des revendications 1 à 9, dans lequel ladite détermination (STP2) pour les accumulateurs électriques (31) de valeurs initiales (Vmes) respectives d'un paramètre de fonctionnement comprend pour chaque accumulateur électrique : mesure d'une tension électrique primaire et d'une tension électrique secondaire à des bornes de l'accumulateur électrique (31) associé respectivement avant et après ledit prélèvement (STP1) au sol d'une énergie électrique ou d'une puissance électrique à prélever à partir de la source d'énergie électrique (30) pendant une durée prédéterminée, ledit paramètre de fonctionnement étant une capacité électrique fonction d'une différence entre la tension électrique primaire et la tension électrique secondaire.

13. Procédé selon l'une quelconque des revendications 1 à 9, dans lequel ladite détermination (STP2) pour les accumulateurs électriques (31) de valeurs initiales (Vmes) respectives d'un paramètre de fonctionnement comprend pour chaque accumulateur électrique : mesure d'une tension électrique primaire et d'une tension électrique secondaire respectivement à des bornes de l'accumulateur électrique (31) associé avant et après ledit prélèvement (STP1) au sol d'une énergie électrique ou d'une puissance électrique à prélever à partir de la source d'énergie électrique (30) pendant une durée prédéterminée, ledit paramètre de fonctionnement étant une résistance électrique fonction d'une différence entre la tension électrique primaire et la tension électrique secondaire.

14. Procédé selon l'une quelconque des revendications 1 à 9, dans lequel ladite détermination (STP2) pour les accumulateurs électriques (31) de valeurs initiales (Vmes) respectives d'un paramètre de fonctionnement comprend pour chaque accumulateur électrique : mesure d'une évolution de température au sein de l'accumulateur électrique au moins pendant ledit prélèvement (STP1) au sol d'une énergie électrique ou d'une puissance électrique à prélever à partir de la source d'énergie électrique (30) pendant une durée prédéterminée, ledit paramètre de fonctionnement étant fonction de ladite évolution de température.

15. Programme d'ordinateur comprenant des instructions qui, lorsque ledit programme est exécuté par un système (40), conduisent ledit système (40) à mettre en oeuvre le procédé selon l'une quelconque des revendications 1 à 14.

16. Aéronef (1) muni d'une installation motrice hybride (10), ladite installation motrice hybride (10) ayant au moins un moteur thermique (15) et au moins un moteur électrique (20) aptes chacun à mettre en mouvement un système mécanique (5), ledit moteur électrique (20) étant relié électriquement à une source d'énergie électrique (30) comprenant un nombre d'accumulateurs électriques (31) supérieur ou égal à deux, ledit aéronef (1) comportant un système (40) d'autorisation de vol configuré pour mettre en oeuvre le procédé selon l'une quelconque des revendications 1 à 14.

17. Aéronef selon la revendication 16, système (40) d'autorisation de vol comportant un senseur (50) configuré pour au moins participer à une mesure des valeurs initiales d'un paramètre de fonctionnement respectivement au sein des bornes des accumulateurs électriques (31), un contrôleur (55) configuré pour requérir le prélèvement au sol d'une énergie électrique ou d'une puissance électrique à prélever à partir de la source d'énergie électrique (30) pendant une durée prédéterminée ainsi que pour calculer la valeur moyenne (Vmoy) et la valeur minimale (Vmin) et pour déterminer si une différence entre la valeur moyenne (Vmoy) et la valeur minimale (Vmin) est inférieure à un seuil (S), et un alerteur (60) configuré pour générer au moins une autorisation de vol ou une interdiction de vol.

## Patentansprüche

1. Verfahren zur Flugfreigabe eines Luftfahrzeugs (1) mit einer Hybridantriebsanlage (10), wobei die Hybridantriebsanlage (10) mindestens einen Verbrennungsmotor (15) und mindestens einen Elektromotor (20) umfasst, die jeweils geeignet sind, ein mechanisches System (5) in Bewegung zu setzen, wobei der Elektromotor (20) elektrisch mit einer elektrischen Energiequelle (30) verbunden ist, die eine Anzahl (Nbr) von elektrischen Akkumulatoren (31) umfasst, die größer oder gleich zwei ist,
wobei das Verfahren die folgenden Schritte umfasst:
- Entnehmen (STP1) von aus der elektrischen Energiequelle (30) entnehmbarer elektrischer Energie oder elektrischer Leistung am Boden während einer vorgegebenen Zeitdauer,
- Bestimmen (STP2) von Anfangswerten (Vmes) eines Betriebsparameters jeweils innerhalb eines jeden der elektrischen Akkumulatoren (31) für die elektrischen Akkumulatoren (31),
- Berechnen (STP3) eines Durchschnittswerts (Vmoy) aus den Anfangswerten (Vmes),
- Bestimmen (STP4) eines Minimalwerts (Vmin), wobei der Minimalwert (Vmin) gleich dem niedrigsten Anfangswert (Vmes) unter den gemessenen Anfangswerten (Vmes) ist,
- Freigeben eines Fluges des Luftfahrzeugs (1), wenn eine Differenz zwischen dem Mittelwert (Vmoy) und dem Minimalwert (Vmin) kleiner als ein Schwellenwert (S) ist, und Verbieten des Fluges des Luftfahrzeugs (1), wenn die Differenz zwischen dem Mittelwert (Vmoy) und dem Minimalwert (Vmin) größer oder gleich dem Schwellenwert (S) ist.

2. Verfahren nach Anspruch 1, bei dem das Entnehmen (STP1) von aus der elektrischen Energiequelle (30) entnehmbarer elektrischer Energie oder elektrischer Leistung am Boden während einer vorgegebenen Zeitdauer ein Betreiben (STP1.1) des Elektromotors (20) im Motormodus umfasst.

3. Verfahren nach einem der Ansprüche 1 bis 2, bei dem das Entnehmen (STP1) von aus der elektrischen Energiequelle entnehmbarer elektrischer Energie oder elektrischer Leistung am Boden während einer vorgegebenen Zeitdauer ein Betreiben (STP1.2) einer vorgegebenen elektrischen Last (75) umfasst, die mit der elektrischen Energiequelle (30) elektrisch verbunden ist.

4. Verfahren nach einem der Ansprüche 1 bis 3, bei dem der Mittelwert (Vmoy) gleich der Summe der Anfangswerte (Vmes) geteilt durch die Anzahl (Nbr) ist.

5. Verfahren nach einem der Ansprüche 1 bis 4, bei dem das Freigeben eines Fluges des Luftfahrzeugs (1) ein Ausgeben eines Flugfreigabesignals umfasst, wenn die Differenz zwischen dem Mittelwert (Vmoy) und dem Minimalwert (Vmin) kleiner als der Schwellenwert (S) ist.

6. Verfahren nach einem der Ansprüche 1 bis 5, bei dem das Verbieten eines Fluges ein Ausgeben eines Flugverbotssignals umfasst, wenn die Differenz zwischen dem Mittelwert (Vmoy) und dem Minimalwert (Vmin) größer oder gleich dem Schwellenwert (S) ist.

7. Verfahren nach einem der Ansprüche 1 bis 6, bei dem der Schwellenwert (S) in einer Vorphase (STP0) bestimmt wird, indem nacheinander die folgenden Schritte durchgeführt werden:
- Entnehmen (STP0.1) der aus der elektrischen Energiequelle (30) entnehmbaren elektrischen Energie oder elektrischen Leistung am Boden während der vorgegebenen Zeitdauer und Bestimmen von jeweiligen Referenzwerten (Vref) des Betriebsparameters für die elektrischen Akkumulatoren (31),
- Außerbetriebsetzen eines elektrischen Akkumulators (311),
- Entnehmen der aus der elektrischen Energiequelle (30) entnehmbaren elektrischen Energie oder elektrischen Leistung am Boden während der vorgegebenen Zeitdauer in Gegenwart eines außer Betrieb gesetzten elektrischen Akkumulators (311), und Bestimmen von jeweiligen Testwerten (Vtest) für den Betriebsparameter zumindest für den oder die in Betrieb befindlichen elektrischen Akkumulatoren,
- Bestimmen, für jeden elektrischen Akkumulator (31), der sich von dem außer Betrieb gesetzten elektrischen Akkumulator unterscheidet, einer Abweichung zwischen dem entsprechenden Referenzwert (Vref) und dem entsprechenden Testwert (Vtest),
- Bestimmen des Schwellenwerts (S) in Abhängigkeit von den Abweichungen.

8. Verfahren nach Anspruch 7, bei dem der Schwellenwert (S) gleich der Hälfte der größten Abweichung unter den Abweichungen ist.

9. Verfahren nach einem der Ansprüche 1 bis 8, bei dem der Schwellenwert (S) fest oder variabel ist.

10. Verfahren nach einem der Ansprüche 1 bis 9,
bei dem der Betriebsparameter eine elektrische Spannung ist, jede elektrische Spannung an Anschlüssen des entsprechenden elektrischen Akkumulators (31) gemessen wird, und das Bestimmen (STP2) von jeweiligen Anfangswerten (Vmes) eines Betriebsparameters während des Entnehmens (STP1) von aus der elektrischen Energiequelle (30) entnehmbarer elektrischer Energie oder elektrischer Leistung am Boden während einer vorgegebenen Zeitdauer für die elektrischen Akkumulatoren (31) durchgeführt wird.

11. Verfahren nach einem der Ansprüche 1 bis 9,
bei dem das Bestimmen (STP2) von jeweiligen Anfangswerten (Vmes) eines Betriebsparameters für die elektrischen Akkumulatoren (31) für jeden elektrischen Akkumulator umfasst: Messen einer elektrischen Primärspannung und einer elektrischen Sekundärspannung an Anschlüssen des entsprechenden elektrischen Akkumulators (31) vor bzw. nach dem Entnehmen (STP1) von aus der elektrischen Energiequelle (30) entnehmbarer elektrischer Energie oder elektrischer Leistung am Boden während einer vorgegebenen Zeitdauer, wobei der Betriebsparameter eine Differenz zwischen der elektrischen Primärspannung und der elektrischen Sekundärspannung ist.

12. Verfahren nach einem der Ansprüche 1 bis 9,
bei dem das Bestimmen (STP2) von jeweiligen Anfangswerten (Vmes) eines Betriebsparameters für die elektrischen Akkumulatoren (31) für jeden elektrischen Akkumulator umfasst: Messen einer elektrischen Primärspannung und einer elektrischen Sekundärspannung an Anschlüssen des entsprechenden elektrischen Akkumulators (31) vor bzw. nach dem Entnehmen (STP1) von aus der elektrischen Energiequelle (30) entnehmbarer elektrischer Energie oder elektrischer Leistung am Boden während einer vorgegebenen Zeitdauer, wobei der Betriebsparameter eine elektrische Kapazität ist, die von einer Differenz zwischen der elektrischen Primärspannung und der elektrischen Sekundärspannung abhängt.

13. Verfahren nach einem der Ansprüche 1 bis 9,
bei dem das Bestimmen (STP2) von jeweiligen Anfangswerten (Vmes) eines Betriebsparameters für die elektrischen Akkumulatoren (31) für jeden elektrischen Akkumulator umfasst: Messen einer elektrischen Primärspannung und einer elektrischen Sekundärspannung jeweils an Anschlüssen des entsprechenden elektrischen Akkumulators (31) vor und nach dem Entnehmen (STP1) von aus der elektrischen Energiequelle (30) entnehmbarer elektrischer Energie oder elektrischer Leistung am Boden während einer vorgegebenen Zeitdauer, wobei der Betriebsparameter ein elektrischer Widerstand ist, der von einer Differenz zwischen der elektrischen Primärspannung und der elektrischen Sekundärspannung abhängt.

14. Verfahren nach einem der Ansprüche 1 bis 9,
bei dem das Bestimmen (STP2) von jeweiligen Anfangswerten (Vmes) eines Betriebsparameters für die elektrischen Akkumulatoren (31) für jeden elektrischen Akkumulator umfasst: Messen einer Temperaturentwicklung innerhalb des elektrischen Akkumulators zumindest während des Entnehmens (STP1) von aus der elektrischen Energiequelle (30) entnehmbarer elektrischer Energie oder elektrischer Leistung am Boden während einer vorgegebenen Zeitdauer, wobei der Betriebsparameter eine Funktion der Temperaturentwicklung ist.

15. Computerprogramm mit Anweisungen, die, wenn das Programm von einem System (40) ausgeführt wird, das System (40) dazu veranlassen, das Verfahren nach einem der Ansprüche 1 bis 14 auszuführen.

16. Luftfahrzeug (1) mit einer Hybridantriebsanlage (10), wobei die Hybridantriebsanlage (10) mindestens einen Verbrennungsmotor (15) und mindestens einen Elektromotor (20) aufweist, die jeweils geeignet sind, ein mechanisches System (5) in Bewegung zu setzen, wobei der Elektromotor (20) elektrisch mit einer elektrischen Energiequelle (30) verbunden ist, die eine Anzahl von elektrischen Akkumulatoren (31) umfasst, die größer oder gleich zwei ist,
wobei das Luftfahrzeug (1) ein Flugfreigabesystem (40) aufweist, das konfiguriert ist, um das Verfahren nach einem der Ansprüche 1 bis 14 durchzuführen.

17. Luftfahrzeug nach Anspruch 16, bei dem das Flugfreigabesystem (40) umfasst:
einen Sensor (50), der konfiguriert ist, um zu einer Messung der Anfangswerte eines Betriebsparameters jeweils an den Klemmen der elektrischen Akkumulatoren (31) zumindest beizutragen,
eine Steuereinheit (55), die konfiguriert ist, um das Entnehmen von aus der elektrischen Energiequelle (30) entnehmbarer elektrischer Energie oder elektrischer Leistung am Boden für eine vorgegebene Zeitdauer anzufordern sowie den Mittelwert (Vmoy) und den Minimalwert (Vmin) zu berechnen und zu bestimmen, ob eine Differenz zwischen dem Mittelwert (Vmoy) und dem Minimalwert (Vmin) unterhalb eines Schwellenwerts (S) liegt,
und einen Alarmgeber (60), der konfiguriert ist, um mindestens eine Flugfreigabe oder ein Flugverbot zu erzeugen.

## Claims

1. Method for authorising the flight of an aircraft (1) provided with a hybrid power plant (10), said hybrid power plant (10) having at least one heat engine (15) and at least one electric motor (20) each capable of moving a mechanical system (5), said electric motor (20) being electrically connected to an electric energy source (30) comprising a number (Nbr) of electric accumulators (31) that is greater than or equal to two,
the method comprising the following steps of:
- ground-based drawing (STP1) of electric energy or electric power that is to be drawn from the electric energy source (30) for a predetermined duration;
- determining (STP2), for the electric accumulators (31), initial values (Vmes) of an operating parameter, respectively within the electric accumulators (31);
- computing (STP3) an average value (Vav) based on the initial values (Vmes);
- determining (STP4) a minimum value (Vmin), with said minimum value (Vmin) being equal to the lowest initial value (Vmes) from among the measured initial values (Vmes);
- authorising a flight of said aircraft (1) when a difference between the average value (Vav) and the minimum value (Vmin) is below a threshold (S) and prohibiting the flight of said aircraft (1) when said difference between the average value (Vav) and the minimum value (Vmin) is greater than or equal to the threshold (S).

2. Method according to claim 1,
wherein said step (STP1) of ground-based drawing of electric energy or electric power that is to be drawn from the electric energy source (30) for a predetermined duration comprises operating (STP1.1) in the motor mode of said electric motor (20).

3. Method according to any one of claims 1 to 2,
wherein said step (STP1) of ground-based drawing of electric energy or electric power that is to be drawn from the electric energy source for a predetermined duration comprises operating (STP1. 2) a predetermined electric load (75) electrically connected to the electric energy source (30).

4. Method according to any one of claims 1 to 3,
wherein said average value (Vav) is equal to the sum of the initial values (Vmes) divided by said number (Nbr).

5. Method according to any one of claims 1 to 4,
wherein said authorization of a flight of said aircraft (1) comprises transmitting a flight authorisation signal when the difference between the average value (Vav) and the minimum value (Vmin) is below the threshold (S).

6. Method according to any one of claims 1 to 5,
wherein said prohibition of the flight comprises transmitting a flight prohibition signal when said difference between the average value (Vav) and the minimum value (Vmin) is greater than or equal to the threshold (S).

7. Method according to any one of claims 1 to 6,
wherein said threshold (S) is determined during a preliminary phase (STP0) by successively carrying out the following steps of:
- ground-based drawing (STP0.1) of electric energy or electric power that is to be drawn from the electric energy source (30) for a predetermined duration, and determining, for the electric accumulators (31), respective reference values (Vref) for said operating parameter;
- rendering an electric accumulator (311) inoperative;
- ground-based drawing of electric energy or electric power that is to be drawn from the electric energy source (30) for the predetermined duration in the presence of an electric accumulator (311) that has been rendered inoperative, and determining, at least for the one or more operative electric accumulators, respective test values (Vtest) for said operating parameter;
- determining, for each electric accumulator (31) other than said electric accumulator that has been rendered inoperative, a deviation between the reference value (Vref) and the corresponding test value (Vtest);
- determining said threshold (S) as a function of said deviations.

8. Method according to claim 7,
wherein said threshold (S) is equal to half the largest deviation from among the deviations.

9. Method according to any one of claims 1 to 8,
wherein said threshold (S) is fixed or variable.

10. Method according to any one of claims 1 to 9,
wherein said operating parameter is an electric voltage, with each electric voltage being measured at terminals of the associated electric accumulator (31), with said determining (STP2), for the electric accumulators (31), of respective initial values (Vmes) of an operating parameter being carried out while implementing the step (STP1) of ground-based drawing of electric energy or electric power that is to be drawn from the electric energy source (30) for a predetermined duration.

11. Method according to any one of claims 1 to 9,
wherein said determining (STP2), for the electric accumulators (31), of respective initial values (Vmes) of an operating parameter comprises, for each electric accumulator: measuring a primary electric voltage and a secondary electric voltage at terminals of the associated electric accumulator (31), respectively before and after said step (STP1) of ground-based drawing of electric energy or electric power that is to be drawn from the electric energy source (30) for a predetermined duration, with said operating parameter being a difference between the primary electric voltage and the secondary electric voltage.

12. Method according to any one of claims 1 to 9,
wherein said determining (STP2), for the electric accumulators (31), of respective initial values (Vmes) of an operating parameter comprises, for each electric accumulator: measuring a primary electric voltage and a secondary electric voltage at terminals of the associated electric accumulator (31), respectively before and after said step (STP1) of ground-based drawing of electric energy or electric power that is to be drawn from the electric energy source (30) for a predetermined duration, with said operating parameter being an electric capacitance dependent on a difference between the primary electric voltage and the secondary voltage electric power.

13. Method according to any one of claims 1 to 9,
wherein said determining (STP2), for the electric accumulators (31), of respective initial values (Vmes) of an operating parameter comprises, for each accumulator: measuring a primary electric voltage and a secondary electric voltage, respectively at terminals of the associated electric accumulator (31) before and after said step (STP1) of ground-based drawing of electric energy or electric power that is to be drawn from the electric energy source (30) for a predetermined duration, with said operating parameter being an electric resistance dependent on a difference between the primary electric voltage and the secondary electric voltage.

14. Method according to any one of claims 1 to 9,
wherein said determining (STP2), for the electric accumulators (31), of respective initial values (Vmes) of an operating parameter comprises, for each accumulator: measuring a change in temperature within the electric accumulator at least during said step (STP1) of ground-based drawing of electric energy or electric power that is to be drawn from the electric energy source (30) for a predetermined duration, with said operating parameter being dependent on said change in temperature.

15. Computer program comprising instructions which, when said program is executed by a system (40), cause said system (40) to implement the method according to any one of claims 1 to 14.

16. Aircraft (1) provided with a hybrid power plant (10), said hybrid power plant (10) having at least one heat engine (15) and at least one electric motor (20) each capable of moving a mechanical system (5), said electric motor (20) being electrically connected to an electric energy source (30) comprising a number of electric accumulators (31) that is greater than or equal to two,
said aircraft (1) comprising a flight authorisation system (40) configured to implement the method according to any one of claims 1 to 14.

17. Aircraft according to claim 16,
the flight authorisation system (40) comprising a sensor (50) configured to at least assist in a measurement of the initial values of an operating parameter, respectively within the terminals of the electric accumulators (31), a controller (55) configured to request ground-based drawing of electric energy or electric power that is to be drawn from the electric energy source (30) for a predetermined duration, as well as to compute the average value (Vav) and the minimum value (Vmin) and to determine whether a difference between the average value (Vav) and the minimum value (Vmin) is below a threshold (S), and an indicator (60) configured to generate at least one flight authorisation or flight prohibition.
